# EUROPÄISCHE PATENTSCHRIFT

(11) **EP 0 559 087 B1**
(45) Veröffentlichungstag und Bekanntmachung des Hinweises auf die Patenterteilung: **17.09.1997**
(21) Anmeldenummer: 93103036.5
(22) Anmeldetag: 26.02.1993
(51) Int. Cl.: G01R 23/10, G01R 23/02

(54) **Digitale Perioden-Messschaltung**
Digital period measuring circuit
Circuit de mesure digital de la période

(30) Priorität: 29.02.1992 DE 4206444
(43) Veröffentlichungstag der Anmeldung: 08.09.1993
(73) Patentinhaber: HONEYWELL AG, D-63008 Offenbach (DE)
(72) Erfinder: Riewe, Franz-Jürgen, W-6458 Rodenbach (DE)
(74) Vertreter: Herzbach, Dieter, Dipl.-Ing.

(56) Entgegenhaltungen:
- DE-A- 2 855 301
- FR-A- 2 378 285
- PATENT ABSTRACTS OF JAPAN vol. 5, no. 154 (P-82)29. September 1981 & JP-A-56 086 361 (YOKOGAWA HOKUSHIN EL.) 14. Juli 1981

## Beschreibung

Die vorliegende Erfindung bezieht sich auf eine Schaltungsanordnung zur digitalen Messung der Periode eines analogen akustischen Signales mit variabler Frequenz nach dem Gattungsbegriff des Patentanspruches 1.

Die Digitalisierung der Periodendauer eines analogen Signales mit variabler Frequenz ist prinzipiell möglich, indem man die Nulldurchgänge des Signales erfaßt und die dazwischenliegenden Zeiten mit einem Zähler auszählt. So zeigt beispielsweise die DE-A1-28 55 301 eine gattungsgemäße Schaltungsanordnung, bei der ein Komparator angeordnet ist zur Umwandlung des analogen Signales in ein Rechteckwellensignal. Ein Flip-Flop erzeugt ein Rückstellsignal für einen Digitalzähler, in den über ein UND-Gatter solange Taktimpulse eines Oszillators eingezählt werden, wie der Ausgang des Flip-Flops gesetzt ist. Je nachdem, ob man die Periodendauer eines positiven oder negativen Signales auszählen will, benötigt man geringfügig abgewandelte Schaltungen, die zwar die gleichen Schaltungselemente aber in anderer Verbindung aufweisen.

Ausgehend von diesem Stand der Technik ist es die Aufgabe der vorliegenden Erfindung, eine einfache Schaltungsanordnung anzugeben, die die digitale Messung der Periode sowohl eines positiven als auch eines negativen Analogsignales gestattet.

Die Lösung dieser Aufgabe gelingt gemäß den kennzeichnenden Merkmalen des Patentanspruches 1. Weitere vorteilhafte Ausgestaltungen der erfindungsgemäßen Schaltungsanordnung sind den Unteransprüchen entnehmbar.

Aus der FR-A-2 378 285 ist eine Schaltungsanordnung zur digitalen Frequenzmessung bekannt, die einen Digitalzähler zur Auszählung von durch einen Taktoszillator erzeugten Taktimpulsen verwendet. Diese Schaltungsanordnung enthält zudem ein Schieberegister, dessen Takteingang mit den Taktimpulsen gespeist ist, wobei die Ausgänge der beiden ersten Stufen des Schieberegisters über ein Exklusiv-ODER-Gatter auf den Rückstelleingang des Digitalzählers geführt sind, dessen Zähleingang direkt mit den Taktimpulsen gespeist ist.

Anhand der Figuren der beiliegenden Zeichnung sei im folgenden ein Ausführungsbeispiel der erfindungsgemäßen Schaltungsanordnung näher beschrieben. Es zeigen:
- Fig. 1a: ein Analogsignal mit variabler Frequenz, wie es von einem Sensor erfaßt wird;
- Fig. 1b: das Signal gemäß Fig. 1a nach Filterung und Verstärkung;
- Fig. 1c: das Signal gemäß Fig. 1b, umgewandelt in ein Rechteckwellensignal gleicher Frequenz;
- Fig. 1d: das mit der erfindungsgemäßen Schaltungsanordnung erzeugte Resetsignal für einen Zähler;
- Fig. 2: ein Blockschaltbild der erfindungsgemäßen Schaltungsanordnung; und
- Fig. 3: das Schaltbild eines Komparators, wie er in Fig. 2 Verwendung findet.

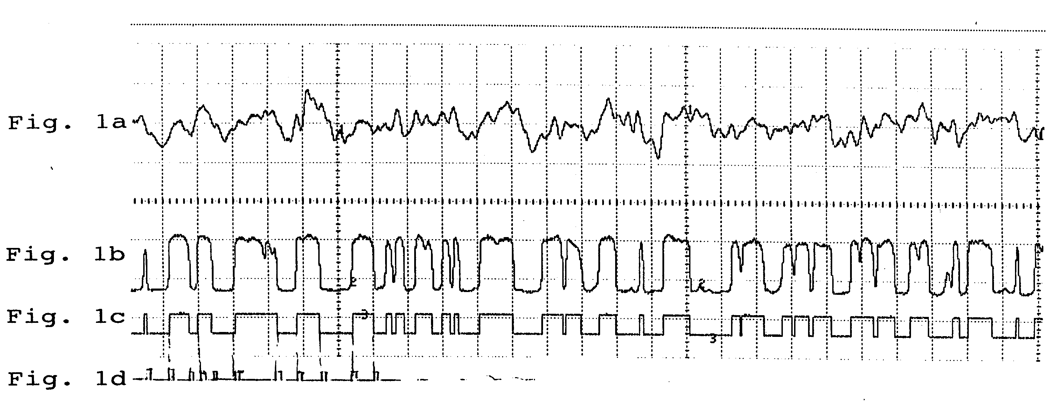

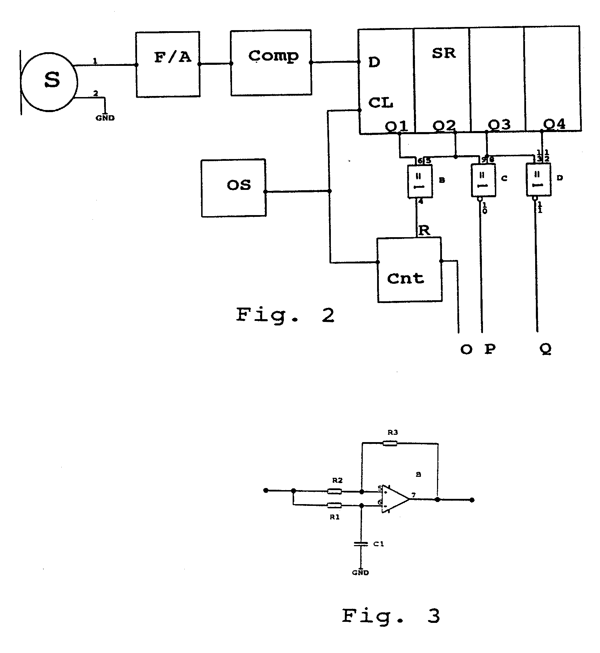

Gemäß Fig. 2 erfaßt ein Sensor S, wie z. B. ein Mikrofon, ein akustisches Signal und gibt dieses in Form einer elektrischen Spannung variabler Frequenz und Amplitude aus, wie dies in Fig. 1a dargestellt ist. Dieses Signal wird einem Filter/ Verstärker-Baustein F/A zugeführt, der höherfrequente Signalkomponenten unterdrückt, das Signal verstärkt und in seiner Amplitude begrenzt. Mit diesem in Fig. 1b dargestellten Signal wird ein Komparator Comp beaufschlagt, der das anliegende Signal in ein Rechteckwellensignal umwandelt, wie dies Fig. 1c entnehmbar ist. Um dieses Komparator-Ausganssignal in ein geeignetes Resetsignal R für einen Zähler Cnt umzusetzen, wird es auf den Dateneingang D eines mindestens zweistufigen Schieberegisters SR gegeben, wobei der Takteingang CL des Schieberegisters SR an einen Taktoszillator OS mit relativ hoher Taktfrequenz angeschlossen ist.

Die Ausgänge Q1, Q2 der beiden ersten Stufen des Schieberegisters SR werden auf die beiden Eingänge eines Exklusiv-ODER-Gatters gegeben, das an seinem Ausgang das Resetsignal R für den Zähler Cnt ausgibt. Weitere Stufen des Schieberegisters SR können mit ihren Ausgängen Q3, Q4 jeweils mit dem davor liegenden Ausgang Q2, Q3 auf die beiden Eingänge von weiteren Exklusiv-ODER-Gattern C, D gegeben werden, um weitere Impulse P, Q zu erzeugen, die der Steuerung der übernahme von Zwischenergebnissen dienen können.

Das Resetsignal R ist in Fig. 1d dargestellt und wird wie folgt erzeugt: Geht man davon aus, daß die Ausgänge Q1, Q2 des Schieberegisters SR anfänglich den Wert 0 jeweils ausgeben, so bildet das Exklusiv-ODER-Gatter Ex-OR auf Grund der Gleichheit der Eingangssignale an seinem Ausgang ein Resetsignal R mit dem Wert 0. Erscheint nunmehr am Ausgang des Komparators Comp ein Impuls mit dem Wert L, so wird mit dem ersten Taktimpuls am Eingang CL dieser Wert am Dateneingang D übernommen und die erste Stufe des Schieberegisters SR gibt am Ausgang Q1 den Wert L aus. Da der Ausgang Q2 weiterhin den Wert 0 ausgibt, bildet das Exklusiv-ODER-Gatter aus beiden Signalen den Wert L, so daß der Zähler Cnt mit diesem Signal zurückgestellt wird. Beim nächsten Takt des Taktoszillators OS und allen nachfolgenden Takten weisen - solange am Dateneingang D der Wert L anliegt - beide Ausgänge Q1, Q2 des Schieberegisters SR den Wert L auf, so daß das Exklusiv-ODER-Gatter ein Resetsignal mit dem Wert 0 bildet, und der Zähler Cnt aus dem Taktoszillator OS hochgezählt werden kann.

Verschwindet der Impuls am Ausgang des Komparators, so wird der entsprechende Wert 0 am Dateneingang D des Schieberegisters SR mit dem ersten Taktimpuls am Eingang CL übernommen, so daß der Ausgang Q1 den Wert 0 aufweist, während der Ausgang Q2 weiterhin den Wert L besitzt. Auf Grund dieser unterschiedlichen Werte gibt das Exklusiv-ODER-Gatter ein Resetsignal mit dem Wert L aus, durch das der Zähler Cnt erneut zurückgesetzt wird. Bei allen weiteren Taktimpulsen geben beide Stufen des Schieberegisters SR den Wert 0 aus, so daß das Resetsignal verschwindet und der Zähler Cnt wieder hochzählen kann usw.

In Fig. 1d sind die Resetimpulse R übertrieben breit dargestellt. Der Schaltung ist entnehmbar, daß bei entsprechend hoher Taktfrequenz des Taktoszillators OS die Resetimpulse durch feine Nadelimpulse vorgegeben sind, so daß die Digitalisierung der Frequenz, wie sie durch die Impulse in Fig. 1c dargestellt ist, kaum verfälscht wird.

Fig. 3 zeigt einen Komparator Comp, der über ein am invertierenden Eingang liegendes Integrierglied R1, C1 einen Referenzwert vorgibt, der der Eingangsgröße nachgeführt wird.

## Patentansprüche

1. Schaltungsanordnung zur digitalen Messung der Periode eines analogen akustischen Signales mit variabler Frequenz, mit einem Komparator (Comp) zur Umwandlung eines diesem analogen akustischen Signal entsprechenden analogen elektrischen Signales in ein Rechteckwellensignal und mit einem Digitalzähler (Cnt) zur Auszählung von durch einen Taktoszillator (OS) erzeuqten Taktimpulsen, **gekennzeichnet durch** ein Schieberegister (SR), dessen Dateneingang (D) mit dem Ausgang des Komparators (Comp) verbunden ist und dessen Takteingang (CL) an den Ausgang des Taktoszillators (OS) angeschlossen ist, wobei die Ausgänge (Q1,Q2) der beiden ersten Stufen des Schieberegisters (SR) über ein Exklusiv-ODER-Gatter (Ex-OR) auf den Rückstelleingang (R) des Digitalzählers (Cnt) geführt sind, der mit seinem Zähleingang direkt an den Ausgang des Taktoszillators (OS) angeschlossen ist und an seinem Ausgang (O) das Meßsignal ausgibt.

2. Schaltungsanordnung nach Anspruch 1, gekennzeichnet durch einen Filter/Verstärker-Baustein (F/A) zwischen einem das analoge akustische Signal erfassenden Sensor (S) und dem Komparator (Comp).

3. Schaltungsanordnung nach Anspruch 1, **gekennzeichnet durch** die Verwendung eines Komparators (Comp) mit einem Integrationsglied (R1,C1) im Eingangszweig, um den Komparator-Referenzwert dem Eingangssignal nachzuführen.

## Claims

1. Circuit device for the digital measuring ofthe period of an analog acoustical signal having a variable frequency comprising a comparator (Comp) for converting an analog electrical signal corresponding to said acoustical signal into a squarewave signal and a digital counter (Cnt) for counting clock pulses produced by a clock oscillator (OS), **characterized by** a shift register (SR), the data input (D) of which being connected to the output of the comparator (Comp) and the clock input (CL) of which being connected to the output ofthe clock oscillator (OS), whereat the outputs (Q1, Q2) of the first two stages of the shift register (SR) are fed to the reset input (R) of the digital counter (Cnt) via an Exclusive-OR-gate (Ex-OR), which counter being connected directly with its counting input to the output ofthe clock oscillator (OS) and delivering at its output (0) the measuring signal.

2. Circuit device according to claim 1, **characterized by** a filter/amplifier component (F/A) between a sensor (S) sensing the analog acoustical signal and the comparator (Comp).

3. Circuit device according to claim 1, **characterized by** the use of a comparator (Comp) comprising an integrating circuit (R1, C1) at its input branch in order to readjust the comparator's reference value to the input signal.

## Revendications

1. Montage pour la mesure numérique de la période d'un signal acoustique analogique à fréquence variable, comportant un comparateur (Comp) servant à convertir un signal électrique analogique, qui correspond à ce signal acoustique analogique, en un signal en onde rectangulaire, et un compteur numérique (Cnt) servant à compter des impulsions de cadencement produites par un oscillateur de cadencement (OS), caractérisé par un registre à décalage (SR), dont l'entrée des données (D) est reliée à la sortie du comparateur (Comp) et dont l'entrée de cadencement (CL) est raccordée à la sortie de l'oscillateur de cadencement (OS), les sorties (Q1,Q2) des deux premiers étages du registre à décalage (SR) étant amenées par l'intermédiaire d'une porte OU-Exclusif (Ex-OR), à l'entrée de remise à zéro (R) du compteur numérique (Cnt) qui est raccordé, par son entrée de comptage, directement à la sortie de l'oscillateur de cadencement (OS) et délivre, à sa sortie (0), le signal de mesure.

2. Montage selon la revendication 1, caractérisé par un module filtre / amplificateur (F/A) disposé entre un capteur (S), qui détecte le signal acoustique analogique, et le comparateur (Comp).

3. Montage selon la revendication 1, caractérisé par l'utilisation d'un comparateur (Comp) comportant un circuit intégrateur (R1,C1) dans la branche d'entrée, pour asservir la valeur de référence du comparateur au signal d'entrée.
